# FASCICULE DE BREVET EUROPEEN

(11) **EP 4 595 727 B1**
(45) Date de publication et mention de la délivrance du brevet: **02.12.2026**
(21) Numéro de dépôt: 23776405.5
(22) Date de dépôt: 28.09.2023
(51) Int. Cl.: H10N 30/07, H10N 30/071, H10N 30/072, H10N 30/073, H10N 30/079

(54) **PROCÉDÉ DE FABRICATION D'UN SUBSTRAT DONNEUR POUR ÊTRE UTILISÉ DANS UN PROCÉDÉ DE TRANSFERT DE COUCHE MINCE PIÉZOÉLECTRIQUE**
VERFAHREN ZUR HERSTELLUNG EINES DONORSUBSTRATS ZUR VERWENDUNG IN EINEM PIEZOELEKTRISCHEN DÜNNSCHICHTÜBERTRAGUNGSVERFAHREN
METHOD OF MANUFACTURING A DONOR SUBSTRATE FOR USE IN A PIEZOELECTRIC THIN-FILM TRANSFER PROCESS

(30) Priorité: 30.09.2022 FR 2209971
(43) Date de publication de la demande: 06.08.2025
(73) Titulaire: SOITEC, 38190 Bernin (FR)
(72) Inventeur: CAPELLO, Luciana, 38190 Bernin (FR); GAUDIN, Gweltaz, 38190 Bernin (FR)
(74) Mandataire: IP Trust
(86) Numéro de dépôt international: PCT/EP2023/076889
(87) Numéro de publication internationale: WO 2024/068840

(56) Documents cités:
- EP-A1- 3 451 363
- EP-A1- 4 016 588
- WO-A1-2021/201220
- WO-A1-2023/135181

## Description

L'invention concerne un procédé de fabrication d'un substrat donneur pour être utilisé dans un procédé de transfert de couche mince piézoélectrique et un substrat donneur obtenu par un tel procédé.

Un substrat piézoélectrique sur isolant (POI) comprend une couche mince de matériau piézoélectrique sur un substrat. Pour fabriquer un tel substrat POI, le procédé utilisé comprend le transfert de la couche mince piézoélectrique sur un substrat support final à partir d'un substrat épais de matériau piézoélectrique.

Pour cela, d'abord un substrat donneur est utilisé dans lequel un substrat massif de matériau piézoélectrique est assemblé à un substrat de manipulation par collage, en particulier en utilisant une couche polymère, ou encore un collage de type collage moléculaire. Ensuite, le substrat donneur subit une étape d'amincissement du substrat massif piézoélectrique pour former une couche piézoélectrique plus mince avant d'être assemblé au substrat support. Finalement, le transfert de la couche piézoélectrique sur le substrat support final est réalisé de manière mécanique ou thermique au niveau d'une zone de fracturation crée au préalable dans la couche piézoélectrique amincie. Le substrat donneur est introduit dans le procédé pour limiter l'impact négatif de la différence des coefficients de dilatation thermique entre le matériau piézoélectrique et le substrat support final du POI. En effet, pour renforcer l'interface de collage entre les différents substrats et pour le transfert de la couche mince, des traitements thermiques sont réalisés. Un exemple de ce type de procédé est décrit dans WO 2019/186032 A1, dans le WO2021/201220 A1, dans le EP40106588 A1, dans le EP3451363 A1, dans le WO2023/135181 A1 (un 54(3) CBE document) ou encore dans WO 2019/002080 A1.

Après plusieurs transferts de couches piézoélectriques sur des substrats support finaux, le substrat donneur restant est disposé car il ne peut plus être utilisé dans quelconque procédé de fabrication due à une limite d'épaisseur en dessous de laquelle un transfert de couche piézoélectrique sur un substrat final n'est plus envisageable. Il est donc nécessaire d'utiliser un nouveau substrat de manipulation pour fabriquer un nouveau substrat donneur pour pouvoir réaliser de nouveau un procédé de transfert de couche piézoélectrique mince pour la fabrication d'un substrat POI.

Ainsi, un tel procédé présente un cout élevé dû à la nécessité d'utiliser un nouveau substrat de manipulation fraichement fabriqué pour chaque procédé de fabrication d'un substrat donneur pour le transfert d'une couche piézoélectrique mince.

Un but de l'invention est de remédier aux inconvénients précités et notamment de fournir un procédé de fabrication d'un substrat donneur qui permet de réduire le cout du procédé de fabrication et par conséquent aussi le cout du procédé de transfert de couche piézoélectrique utilisant un tel substrat donneur.

L'objet de l'invention est réalisé par un procédé de transfert d'une couche mince piézoélectrique comprenant: a) fournir un substrat donneur comprenant un substrat de manipulation massif, en particulier à base de silicium, avec une zone de fragilisation, et un matériau piézoélectrique le matériau piézoélectrique étant au-dessus du substrat de manipulation massif, b) former une zone de fragilisation à l'intérieur du matériau piézoélectrique du substrat donneur, en particulier par implantation ionique, c) fournir un substrat support final, en particulier un substrat à base de silicium, d) attacher le substrat donneur au substrat final pour obtenir un assemblage substrat donneur - substrat support final, et e) réaliser une fracture le long de la zone de fragilisation du matériau piézoélectrique pour séparer une couche piézoélectrique du restant du substrat donneur.

Selon un mode de réalisation, l'étape e) de fracture le long de la zone de fragilisation du matériau piézoélectrique peut être réalisée à une température inférieure à la température utilisée pour réaliser la fracture à la zone de fragilisation du substrat de manipulation massif du substrat donneur.

Selon un mode de réalisation, les étapes a) à e) peuvent être répétées au moins une fois et à partir de la deuxième itération, l'étape a) peut être réalisée avec le restant du substrat donneur obtenu à la fin de l'étape e) de l'itération précédente.

Selon un mode de réalisation, les étapes a) à e) peuvent être répétées tant que l'épaisseur de la couche piézoélectrique du restant du substrat donneur obtenu à l'étape e) est supérieure à 5µm.

Selon un mode de réalisation, une étape f) de fracture du restant du substrat donneur au niveau de la zone de fragilisation du substrat de manipulation massif peut être réalisée après l'étape e).

Selon un mode de réalisation, l'étape f) de fracture peut être réalisée lorsque l'épaisseur de la couche piézoélectrique du restant du substrat donneur obtenu à l'étape e) est égale ou inférieure à 5µm, pour obtenir un restant de substrat de manipulation massif.

Selon un mode de réalisation, l'étape f) de fracture le long de la zone de fragilisation du substrat de manipulation massif du restant du substrat donneur peut être réalisée par un traitement thermique.

Selon un mode de réalisation, le substrat donneur fourni à l'étape a) peut être obtenu par la mise en œuvre d'un procédé de fabrication d'un substrat donneur pour le transfert d'une couche piézoélectrique sur un substrat support final. Ledit procédé de fabrication d'un substrat donneur pour le transfert d'une couche piézoélectrique sur un substrat support final peut comprendre les étapes de : a) fournir un substrat de manipulation massif, en particulier à base de silicium; c) fournir un matériau piézoélectrique au-dessus du substrat de manipulation massif; et comprendre en outre une étape b) d'implantation du substrat de manipulation massif pour réaliser une zone de fragilisation dans le substrat de manipulation massif avant l'étape de fournir le matériau piézoélectrique.

Selon un mode de réalisation, l'étape a) de fournir un substrat de manipulation massif (102) peut comprendre utiliser le restant du substrat de manipulation massif obtenu après l'étape f) du procédé de transfert d'une couche mince piézoélectrique précédemment décrite.

Selon un mode de réalisation, une étape g) de traitement de la surface du restant du substrat de manipulation massif peut être réalisée après l'étape f) du procédé de transfert d'une couche mince piézoélectrique précédemment décrite.

Selon un mode de réalisation, ladite étape b) d'implantation du substrat de manipulation massif peut être réalisée avec une dose d'implantation inférieure à 6*10¹⁶ cm⁻², en particulier inférieure à 5x10¹⁶ cm⁻², encore plus en particulier une implantation d'hydrogène, H, d'hélium, He ou une co-implantation d'hydrogène, H et d'hélium, H

Selon un mode de réalisation, une étape c1) de fournir une couche intermédiaire entre le substrat de manipulation massif et le matériau piézoélectrique peut être réalisée avant ladite étape c) de fournir un matériau piézoélectrique au-dessus du substrat de manipulation massif.

Selon un mode de réalisation, ladite étape c) de fournir un matériau piézoélectrique au-dessus du substrat de manipulation massif peut comprendre fournir un substrat massif à base de matériau piézoélectrique

Selon un mode de réalisation, ladite étape c) de fournir un matériau piézoélectrique au-dessus du substrat de manipulation massif peut comprendre en outre une étape d'assemblage du substrat de manipulation massif avec le substrat massif à base de matériau piézoélectrique, en particulier par bondage moléculaire.

Selon un mode de réalisation, une étape d) d'amincissement du matériau piézoélectrique peut être réalisée, en particulier par meulage, plus en particulier durant ledit procédé de fabrication d'un substrat donneur pour le transfert d'une couche piézoélectrique sur un substrat support final.

Selon un mode de réalisation, ladite étape d) d'amincissement du matériau piézoélectrique peut être réalisée pour obtenir une couche du matériau piézoélectrique avec une épaisseur de 30µm ou moins, en particulier de 20µm ou moins.

Selon un mode de réalisation, ladite étape c) de fournir un matériau piézoélectrique au-dessus du substrat de manipulation massif peut être réalisée par déposition par épitaxie d'une couche à base de matériau piézoélectrique sur le substrat de manipulation massif.

Selon un mode de réalisation, l'étape de déposition par épitaxie peut être réalisée à une température inférieure à 950°C, en particulier inférieure à 900°.

Selon un mode de réalisation, le substrat donneur fourni à l'étape a) dudit procédé de transfert peut être caractérisé en ce que la zone de fragilisation est positionnée à une profondeur t dans le substrat de manipulation massif de 500nm, en particulier à une profondeur t dans le substrat de manipulation massif de 300nm, encore plus en particulier à une profondeur t dans le substrat de manipulation massif inférieure à 300nm.

Selon un mode de réalisation, le substrat donneur fourni à l'étape a) dudit procédé de transfert peut être caractérisé en ce que le substrat de manipulation massif est un substrat de carbure de silicium, SiC et le matériau piézoélectrique est du nitrure de gallium, GaN.

L'objet de l'invention peut aussi être réalisé par un procédé de fabrication d'un substrat donneur pour le transfert d'une couche piézoélectrique sur un substrat support final comprenant les étapes de a) fournir un substrat de manipulation massif, en particulier à base de silicium; c) fournir un matériau piézoélectrique au-dessus du substrat de manipulation massif; caractérisé en ce que le procédé comprend en outre une étape b) d'implantation ionique du substrat de manipulation massif pour réaliser une zone de fragilisation dans le substrat de manipulation massif avant l'étape c) de fournir le matériau piézoélectrique.

Ainsi, le substrat donneur fabriqué par le procédé selon l'invention peut être fracturé au niveau du substrat de manipulation massif lors d'une étape postérieure. La fracture au niveau de la zone de fragilisation du substrat de manipulation massif du substrat donneur permet d'obtenir un restant de substrat de manipulation massif qui peut être de nouveau utilisé dans d'autres procédés ultérieurs. Ainsi, le cout associé à la fabrication d'un substrat de manipulation massif peut être réduit grâce à la réutilisation ou au recyclage d'une partie du substrat de manipulation massif.

Selon un mode de réalisation, l'étape b) d'implantation du substrat de manipulation massif peut être réalisée avec une dose d'implantation inférieure à 6*10¹⁶ cm⁻², en particulier inférieure à 5*10¹⁶ cm⁻², encore plus en particulier une implantation d'hydrogène, H, d'hélium, He ou une co-implantation d'hydrogène, H et d'hélium, He.

Ainsi, la zone de fragilisation dans le substrat de manipulation massif est positionnée à une profondeur dans le substrat de manipulation massif inférieure à 500nm, en particulier égale à 300nm. Cette profondeur permet d'obtenir une couche mince du substrat de manipulation massif à retirer lors de l'étape de fracture correspondante. Ainsi, le restant du substrat de manipulation massif comprend une épaisseur toujours viable pour pouvoir être réutilisé dans un procédé ultérieur.

Selon un mode de réalisation, une étape c1) de fournir une couche intermédiaire entre le substrat de manipulation massif et le matériau piézoélectrique peut être réalisée avant l'étape c).

Ainsi, l'assemblage entre le substrat de manipulation massif et le matériau piézoélectrique peut être amélioré par la présence de la couche intermédiaire. De plus, la couche intermédiaire permet de simplifier la formation de la structure d'assemblage.

Selon un mode de réalisation, l'étape c) de fournir un matériau piézoélectrique au-dessus du substrat de manipulation massif peut comprendre fournir un substrat massif à base de matériau piézoélectrique.

Le procédé selon l'invention peut utiliser une grande variété de matériaux piézoélectrique, qui jouent un rôle majeur dans les dispositifs exploitant l'effet piézoélectrique. Par exemple, du tantalate de lithium, LTO, du niobate de lithium, LNO, du nitrure d'aluminium, AIN, du titano-circonate de plomb, PZT, de la langasite, LGS ou du langatate, LGT, peuvent être utilisés.

Selon un mode de réalisation, l'étape c) peut comprendre en outre une étape d'assemblage du substrat de manipulation massif avec le substrat massif à base de matériau piézoélectrique, en particulier par collage moléculaire.

Ainsi, l'étape d'assemblage permet de combiner un large nombre de matériaux différents. De plus, l'interface entre le substrat de manipulation massif et le matériau piézoélectrique est une interface d'assemblage stable.

Selon un mode de réalisation, une étape d) d'amincissement du matériau piézoélectrique peut être réalisée, en particulier par meulage.

Ainsi, à partir d'un substrat épais piézoélectrique, une couche piézoélectrique d'une épaisseur voulue est obtenue et le substrat donneur fabriqué selon le procédé de l'invention peut être utilisé pour le transfert d'une couche piézoélectrique mince sur un substrat support pour obtenir un substrat piézoélectrique sur isolant (POI) avec les propriétés voulues.

Selon un mode de réalisation, l'étape d) d'amincissement peut être réalisée pour obtenir une épaisseur du matériau piézoélectrique de 30µm ou moins, en particulier de 20µm ou moins.

Le substrat donneur ainsi fabriqué par le procédé selon l'invention peut être utilisé comme substrat donneur dans un processus ultérieur de transfert de couche pour transférer une fine couche du matériau piézoélectrique sur un substrat support final pour former ainsi un substrat piézoélectrique sur isolant (POI). Dans un procédé de fabrication d'un substrat POI, le matériau piézoélectrique et le matériau du substrat support final présentant des coefficients de dilatation thermique très différents, une déformation importante de l'assemblage survient. Dans un tel procédé, grâce à l'usage d'un substrat donneur, le substrat piézoélectrique épais est maintenu entre le substrat de manipulation et le substrat support. Le choix des matériaux et des épaisseurs du substrat de manipulation et du substrat support final permet de réduire l'impact des coefficients de dilatation thermique, et ainsi de minimiser la déformation de l'assemblage lors l'application de traitements thermiques lors du procédé de fabrication d'un substrat piézoélectrique sur isolant (POI). Par exemple, la différence de coefficient de dilatation thermique entre le matériau du substrat de manipulation et le matériau du substrat support final est inférieure ou égale à 5%, et de préférence égale ou voisine de 0%.

Selon un mode de réalisation, l'étape c) de fournir un matériau piézoélectrique peut être réalisée par déposition par épitaxie de la couche à base de matériau piézoélectrique.

Ainsi, le procédé permet d'obtenir de manière contrôlée une couche de matériau piézoélectrique d'une épaisseur voulue et prédéterminée d'une qualité permettant une utilisation dans des dispositifs SAW. Par exemple, une couche de nitrure de gallium, GaN peut ainsi être obtenue, qui est un matériau piézoélectrique intéressant pour la fabrication de substrats POI.

Selon un mode de réalisation, l'étape de déposition par épitaxie peut être réalisée à une température inférieure à 950°C, en particulier à 900°C.

Ainsi, une couche épaisse de matériau piézoélectrique peut être obtenue de bonne qualité pour utilisation dans des dispositifs SAW ultérieurement. Par exemple, le substrat de manipulation massif peut être un substrat de carbure de silicium, SiC, et le matériau piézoélectrique peut être une couche de nitrure de gallium, GaN.

L'objet de l'invention peut aussi être réalisé par un substrat donneur, en particulier un substrat donneur obtenu par le procédé décrit précédemment, comprenant un substrat de manipulation massif, en particulier à base de silicium; un matériau piézoélectrique au-dessus du substrat de manipulation massif; caractérisé en ce que le substrat de manipulation massif comprend une zone de fragilisation.

Un tel substrat donneur, en particulier fabriqué selon le procédé de l'invention, peut être utilisé pour le transfert d'une couche piézoélectrique mince sur un substrat support pour obtenir un substrat piézoélectrique sur isolant (POI). De plus, la présence de la zone de fragilisation dans le substrat de manipulation massif permet de recycler une partie du substrat donneur en réalisant une fracture au niveau de la zone de fragilisation du substrat donneur, une fois le procédé de transfert d'une couche mince piézoélectrique réalisé. La fracture le long de la zone de fragilisation du substrat de manipulation peut être réalisée par un traitement thermique ou mécanique.

Selon un mode de réalisation, la zone de fragilisation dans le substrat de manipulation massif peut être positionnée à une profondeur t dans le substrat de manipulation massif de 500nm, en particulier à une profondeur t dans le substrat de manipulation massif de 300nm, encore plus en particulier à une profondeur t dans le substrat de manipulation massif inférieure à 300nm.

Selon un mode de réalisation, le substrat de manipulation massif peut être un substrat de carbure de silicium, SiC, et le matériau piézoélectrique peut être une couche de nitrure de gallium, GaN.

Cette combinaison de matériau est très intéressante pour son utilisation ultérieure dans des dispositifs de puissance adressant des tensions de 1200V ou plus ou des dispositifs Radiofréquence (RF) ou optoélectroniques type micro-LED.

L'objet de l'invention peut aussi être réalisé par un procédé de transfert d'une couche mince piézoélectrique comprenant a) fournir un substrat donneur comprenant un substrat de manipulation massif avec une zone de fragilisation décrit précédemment ou obtenu par la mise en œuvre du procédé de fabrication décrit précédemment, b) former une zone de fragilisation à l'intérieur du matériau piézoélectrique du substrat donneur, en particulier par implantation ionique, c) fournir un substrat support final, en particulier un substrat à base de silicium, d) attacher le substrat donneur au substrat support final pour obtenir un assemblage substrat donneur - substrat support final, et e) réaliser une fracture le long de la zone de fragilisation du matériau piézoélectrique pour séparer une couche piézoélectrique du restant du substrat donneur.

Dans un procédé de fabrication d'un substrat POI, le matériau piézoélectrique et le matériau du substrat support présentant des coefficients de dilatation thermique très différents, une déformation importante de l'assemblage survient. Dans un tel procédé, grâce à l'usage d'un substrat donneur, le substrat piézoélectrique épais est maintenu entre le substrat de manipulation et le substrat support final. Le choix des matériaux et des épaisseurs du substrat de manipulation et du substrat support final permet d'assurer une certaine symétrie des coefficients de dilatation thermique, et ainsi de minimiser la déformation de l'assemblage lors l'application de traitements thermiques lors du procédé de fabrication d'un substrat piézoélectrique sur isolant (POI). Par exemple, la différence de coefficient de dilatation thermique entre le matériau du substrat de manipulation et le matériau du substrat support final est inférieure ou égale à 5%, et de préférence égale ou voisine de 0%.

Selon un mode de réalisation, l'étape e) de fracture le long de la zone de fragilisation du matériau piézoélectrique peut être réalisée à une température inférieure à la température utilisée pour réaliser la fracture à la zone de fragilisation du substrat de manipulation massif du substrat donneur.

Ainsi, seulement la fracture à la zone de fragilisation du matériau piézoélectrique est réalisée durant cette étape du procédé. L'apport énergétique pour réaliser une fracture à la zone de fragilisation du substrat de manipulation massif n'est pas suffisant, la fracture étant réalisée à une température inférieure à l'apport énergétique nécessaire.

Selon un mode de réalisation, les étapes a) à e) peuvent être répétées au moins une fois et à partir de la deuxième itération, l'étape a) est réalisée avec le restant du substrat donneur obtenu à la fin de l'étape e) de l'itération précédente.

Ainsi, le restant du substrat donneur peut être recyclé et réutilisé même plusieurs fois. Cela permet de réduire le cout du procédé, car à partir d'un seul substrat donneur, plusieurs substrats POI peuvent être réalisés.

Selon un mode de réalisation, les étapes a) à e) peuvent être répétées tant que l'épaisseur de la couche piézoélectrique du restant du substrat donneur obtenu à l'étape e) est supérieure à 5µm.

Ainsi, le restant du substrat donneur peut être recyclé et réutilisé tant que la couche piézoélectrique restante sur le restant du substrat donneur est d'une épaisseur suffisante pour pouvoir transférer une couche mince piézoélectrique sur le substrat support final. Cela permet de réduire le cout du procédé, car à partir d'un seul substrat donneur, plusieurs substrats POI peuvent être réalisés.

Selon un mode de réalisation, une étape f) de fracture du restant du substrat donneur au niveau de la zone de fragilisation du substrat de manipulation massif peut être réalisée après l'étape e).

Ainsi, un restant de substrat de manipulation massif peut être obtenu, avec une surface supérieure libre. Ce restant de substrat de manipulation massif peut être réutilisé pour fabriquer un nouveau substrat donneur comme décrit ci-dessus.

Selon un mode de réalisation, l'étape f) de fracture du restant du substrat donneur au niveau de la zone de fragilisation du substrat de manipulation massif peut être réalisée lorsque l'épaisseur de la couche piézoélectrique du restant du substrat donneur obtenu à l'étape e) est égale ou inférieure à 5µm pour obtenir un restant du substrat de manipulation massif.

L'étape de fracture du restant du substrat donneur permet de séparer la couche restante de piézoélectrique d'épaisseur égale ou inférieure à 5µm, la ou les couches intermédiaires et une partie du substrat de manipulation massif. Ainsi, un restant de substrat de manipulation massif peut être obtenu, avec une surface supérieure libre qui peut être réutilisé pour fabriquer un nouveau substrat donneur comme décrit ci-dessus.

Selon un mode de réalisation, l'étape f) de fracture le long de la zone de fragilisation du substrat de manipulation massif du restant du substrat donneur peut être réalisée par un traitement thermique.

Un apport thermique important est nécessaire pour réaliser la fracture dans le substrat de manipulation massif. Ainsi, la fracture du substrat de manipulation massif au niveau de la zone de fragilisation ne peut pas avoir lieu lors d'autres traitements thermiques réalisés auparavant dans le procédé de transfert d'une couche mince piézoélectrique.

Selon un mode de réalisation, l'étape a) de fournir un substrat de manipulation massif du procédé de fabrication d'un substrat donneur selon l'invention peut comprendre utiliser le restant du substrat de manipulation massif obtenu après l'étape f) du procédé de transfert décrit précédemment.

Ainsi, une partie du substrat de manipulation massif peut être recyclée et réutilisée après avoir déjà servie dans un procédé de transfert. Cela permet de réduire les couts associés à **la** production de substrat de manipulation massif pour la fabrication de substrat donneur pour un transfert de couche mince piézoélectrique, et ainsi aux couts associés à la production de substrats POI.

Selon un mode de réalisation, une étape g) de traitement de la surface libre du restant du substrat de manipulation massif peut être réalisée après l'étape f) du procédé de transfert décrit précédemment.

Ainsi, la surface libre du restant du substrat de manipulation massif est libre de particules et le restant du substrat de manipulation peut être réutilisé comme substrat de manipulation massif pour fabriquer un substrat donneur. Par exemple, l'étape g) de traitement est une étape de nettoyage de type CMP ou encore une étape de nettoyage utilisant un spray nettoyant.

L'invention et ses avantages seront expliqués plus en détail dans la suite au moyen de modes de réalisation préférés et en s'appuyant notamment sur les figures d'accompagnement suivantes, dans lesquelles les numéros de référence identifient des caractéristiques de l'invention.
Figure 1a représente schématiquement un procédé de fabrication d'un substrat donneur selon un premier mode de réalisation de l'invention.
Figure 1b représente schématiquement un procédé de fabrication d'un substrat donneur selon une variante du premier mode de réalisation de l'invention.
Figure 2 représente schématiquement un procédé de fabrication d'un substrat donneur selon un deuxième mode de réalisation de l'invention.
Figure 3a représente schématiquement les étapes a) à d) d'un procédé de transfert d'une couche mince piézoélectrique selon un troisième mode de réalisation de l'invention.
Figure 3b représente schématiquement les étapes e) et f) du procédé de transfert d'une couche mince piézoélectrique selon le troisième mode de réalisation de l'invention illustré à la figure 3a.
Figure 3c représente par diagramme le procédé de transfert d'une couche mince piézoélectrique selon le troisième mode de réalisation de l'invention.
Figure 3d représente schématiquement un procédé de transfert d'une couche mince piézoélectrique selon une variante du troisième mode de réalisation de l'invention.
Figure 4a représente schématiquement un procédé de transfert d'une couche mince piézoélectrique selon un quatrième mode de réalisation de l'invention.
Figure 4b représente schématiquement un procédé de fabrication d'un substrat donneur selon un cinquième mode de réalisation de l'invention.

L'invention va être décrite plus en détail en utilisant des modes de réalisation avantageux d'une manière exemplaire et en référence aux dessins. Les modes de réalisation décrits sont simplement des configurations possibles et il faut garder à l'esprit que les caractéristiques individuelles telles que décrites ci-dessus peuvent être fournies indépendamment les unes des autres ou peuvent être omises tout à fait lors de la mise en oeuvre de la présente invention.

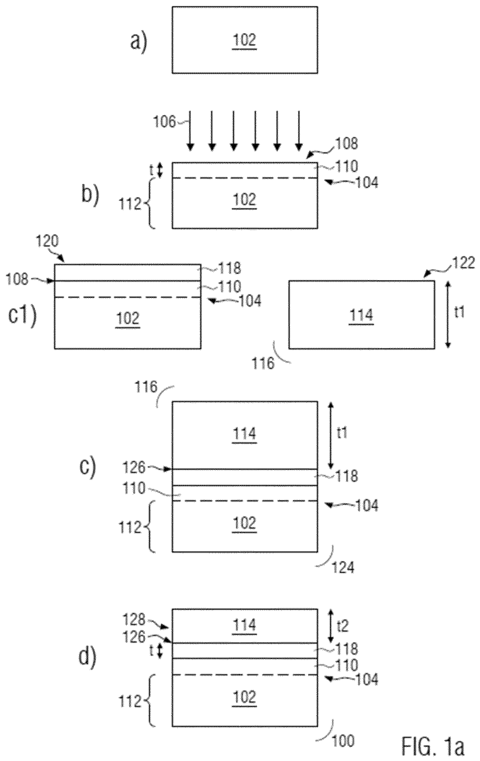

La Figure 1a représente un procédé de fabrication d'un substrat donneur selon un premier mode de réalisation de l'invention.

Le procédé de fabrication d'un substrat donneur 100 commence par l'étape a) de fournir un substrat de manipulation massif 102. Un substrat massif est un substrat à base d'un seul matériau typiquement d'une épaisseur comprise entre 300µm et 800µm.

Le substrat de manipulation massif 102 est fait avantageusement d'un matériau dont le coefficient de dilatation thermique est proche de celui du matériau du substrat support final sur lequel la couche mince piézoélectrique est destinée à être transférée. Par « proche », on entend une différence de coefficient de dilatation thermique entre le matériau du substrat de manipulation 102 et le matériau du substrat support final inférieure ou égale à 5%, et de préférence égale ou voisine de 0%.

Le substrat de manipulation massif 102 peut être un substrat à base de silicium. Dans une variante, le substrat de manipulation massif 102 peut aussi être à base de saphir, Al₂O₃, de nitrure de aluminium, de carbure de silicium, SiC ou encore d'arséniure de gallium, GaAs, **Le** substrat de manipulation massif 102 peut être un substrat cristallin ou poly cristallin.

Selon l'invention, l'étape b) consiste en la formation d'une zone de fragilisation 104 dans le substrat de manipulation massif 102. La formation de la zone de fragilisation 104 est réalisée par une étape b) d'implantation 106 d'espèces atomiques ou ioniques dans le substrat de manipulation massif 102. L'implantation 106 atomique ou ionique est réalisée sur la surface libre 108 du substrat de manipulation massif 102. L'implantation 106 atomique ou ionique peut être réalisée de telle manière que la zone de fragilisation 104 est située à l'intérieure du substrat de manipulation massif 102 à une profondeur t de la surface libre 108 et sépare une couche 110 du reste 112 du substrat de manipulation massif 102. Les espèces atomiques ou ioniques sont implantées à une profondeur t déterminée du substrat de manipulation massif 102 qui détermine l'épaisseur t de la couche 110. L'épaisseur t est de l'ordre de 300nm, en particulier inférieure à 300nm.

L'implantation 106 ionique peut être une implantation d'ions d'hydrogène, H+ ou d'ions d'hélium He2+ ou encore une co-implantation d'ions d'hydrogène, **H** et d'hélium He. La dose d'implantation des espèces ioniques est inférieure à 6*10¹⁶ cm⁻², en particulier la dose d'implantation est comprise entre 4*10¹⁶ cm⁻² et 6*10¹⁶ cm⁻² pour un substrat de manipulation en Silicium.

Selon une variante, des étapes de traitement de surface de la surface libre 108 du substrat de manipulation massif 102 peuvent être réalisées avant l'implantation 106 du substrat de manipulation massif 102. Par exemple, un traitement de nettoyage de type dit RCA.

Lors de l'étape c), un matériau piézoélectrique 114 est fourni au-dessus du substrat de manipulation massif 102.

Il s'agit de préférence d'un substrat massif 116 formé d'un seul matériau piézoélectrique 114 dont l'épaisseur t1 est typiquement de l'ordre d'au moins 300µm, de préférence entre 300µm et 800µm.

Le matériau piézoélectrique 114 peut, par exemple, être du tantalate de lithium, LTO, du niobate de lithium, LNO, du nitrure d'aluminium, AIN, du titano-circonate de plomb, PZT, de la langasite, LGS ou du langatate, LGT.

**Selon** l'invention, une étape c1) de fournir au moins une couche intermédiaire 118 entre le substrat de manipulation massif 102 et le matériau piézoélectrique 114 est réalisée avant l'étape c), de telle manière que la couche intermédiaire 118 est positionnée en sandwich entre le substrat de manipulation massif 102 et le matériau piézoélectrique 114.

La couche intermédiaire 118 peut être fournie sur le substrat de manipulation massif 102, en particulier sur la surface libre 108 du substrat de manipulation massif 102. La couche intermédiaire 118 peut être déposée directement sur la surface libre 108 du substrat de manipulation massif 102. La formation de la couche intermédiaire 118 sur la surface libre 108 du substrat de manipulation massif 102 peut être réalisée par un dépôt par enduction centrifuge, ou « spin coating » en anglais ou par une technique de croissance thermique ou assisté par plasma telle que un dépôt chimique en phase vapeur activé par plasma PECVD (acronyme de l'expression anglaise « Plasma Enhanced Chemical Vapor Deposition ») ou la technique de dépôt physique en phase vapeur PVD (acronyme de l'expression anglaise « Physical Vapor Deposition »).

Avant de réaliser la formation de la couche intermédiaire 118, une ou plusieurs étapes de nettoyage, de brossage ou de polissage de la surface 108 du substrat de manipulation massif 102 peut / peuvent être réalisées pour enlever la présence de particules et de poussière pour obtenir ainsi une surface libre 108 plus propre ce qui permet l'obtention d'une couche intermédiaire 118 de meilleure qualité.

La couche intermédiaire 118 formée sur le substrat support massif 102 peut être une couche diélectrique, par exemple une couche à base d'oxyde de silicium, SiOx,ou à base de nitrure de silicium, Si₃N₄, ou encore une couche comprenant une combinaison de nitrure et d'oxyde de silicium, SiOₓN_{y}, ou à base d'oxyde de tantale, Ta₂O₅, à base d'oxyde d'aluminium, Al₂O₃, d'oxyde d'hafnium, HfO₂, et d'oxyde de zirconium, ZrO₂. Suivant la technologie utilisée pour le collage, la couche intermédiaire 118 formée sur le substrat support massif 102 peut être également une couche de silicium ou de carbone amorphe ou de métal.

La couche intermédiaire 118 a une épaisseur comprise entre 2nm et 1000nm.

Dans une variante, la couche intermédiaire 118 formée sur le substrat de manipulation massif 102 peut être une couche polymère photo-polymérisable, en particulier à base de résine thiolène. La couche polymère 118 utilisée dans la présente invention peut être par exemple une couche commercialisée sous la référence « NOA 61 » par la société NORLAND PRODUCTS. Dans ce cas, l'épaisseur de la couche polymère 118 est de préférence comprise entre 1 et 10µm.

La couche polymère 118 seule permet de réaliser une bonne adhésion à une autre couche ou un autre substrat. En effet, après l'étape d'assemblage du procédé de fabrication d'un substrat donneur, une étape de traitement de la couche polymère 118 pour obtenir une couche polymère réticulée pour coller le substrat de manipulation 102 au matériau piézoélectrique 114 peut être réalisée. Un traitement de réticulation peut être réalisé sur la couche polymère 118 par usage de chaleur, de pression, par un changement de pH ou par de l'irradiation par un flux lumineux 118, de préférence un laser. Le rayonnement lumineux 118, ou flux lumineux, est de préférence un rayonnement ultra-violet (UV), de préférence d'une longueur d'onde comprise entre 320nm et 365nm.

Ainsi, lors de l'étape d'assemblage comprise lors de l'étape c), le matériau piézoélectrique 114 est assemblé avec le substrat de manipulation massif 102 pour former une héterostructure 124, en mettant en contact la couche intermédiaire 118 avec le matériau piézoélectrique 114. Ainsi, l'interface d'assemblage 126 est située entre le matériau piézoélectrique 114 et la couche intermédiaire 118 du substrat de manipulation 102.

Selon l'invention, une étape d) d'amincissement du matériau piézoélectrique 114 est réalisée après l'étape d'assemblage de l'étape c). L'amincissement est réalisé par meulage ou bien par un procédé de gravure chimique du matériau piézoélectrique 114 pour réduire l'épaisseur *t₁* du matériau piézoélectrique 114 pour obtenir une couche piézoélectrique 128 d'une épaisseur *t₂* de l'ordre de 20µm, ou encore entre 5µm et 20µm.

Ainsi, l'assemblage 100 substrat de manipulation massif - matériau piézoélectrique, aussi appelé substrat donneur 100, est réalisé à la fin de l'étape d) du procédé comprenant une couche piézoélectrique 128 d'une épaisseur de 20µm ou entre 5µm et 20µm sur un substrat de manipulation massif 102 comprenant une zone de fragilisation 104, avec une interface d'assemblage 126 réalisée par une couche intermédiaire 118 en sandwich entre le substrat de manipulation massif 102 et la couche 128 de matériau piézoélectrique 114.

Dans une variante, la couche intermédiaire 118 peut être fournie sur le matériau piézoélectrique 114 au lieu de sur le substrat de manipulation massif 102, en particulier sur la surface libre 122 du matériau piézoélectrique 114.

Selon une autre variante, le matériau piézoélectrique 114 peut être fourni directement sur le substrat de manipulation massif 102, sans la présence d'une couche intermédiaire 118 entre les deux.

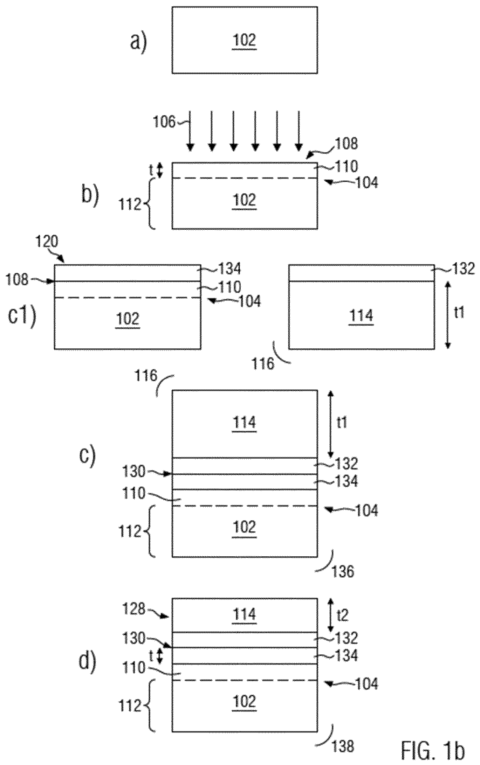

La figure 1b montre une variante du premier mode de réalisation de l'invention dans lequel l'étape c1) de fournir une couche intermédiaire 118 est différente par rapport au premier mode de réalisation. L'étape de dépôt de la couche intermédiaire 118 est réalisée sur le substrat de manipulation massif 102 et sur le matériau piézoélectrique 114. Toutes les autres étapes a), b), c) et d) sont les mêmes que dans le premier mode de réalisation. Toutes les caractéristiques communes avec le premier mode de réalisation et utilisant le même numéro de référence que ci-dessus ne seront pas décrites à nouveau, mais il est fait référence à leur description détaillée ci-dessus.

A l'étape c1), une couche intermédiaire 132 est fournie sur le matériau piézoélectrique 114 et une couche intermédiaire 134 est fournie sur le substrat de manipulation massif 102. L'assemblage 136 du substrat de manipulation 102 avec le matériau piézoélectrique 114 est ensuite réalisée à l'interface entre les deux couches intermédiaires 132, 134. En particulier, les couches intermédiaires 132, 134 sont à base de matériau diélectrique, et l'interface 130 est réalisée avec des liaisons de type oxyde - oxyde, en particulier une liaison de type Si-O-Si, qui permet une liaison par force moléculaire stable.

Dans une autre variante, les couches intermédiaires 132, 134 fournies sur le matériau piézoélectrique 114 et sur le substrat de manipulation massif 102 sont composées de différents matériaux diélectriques. Par exemple, la couche intermédiaire 132 fournie sur le substrat de manipulation massif 102 est une couche de niture de silicium, Si₃N₄ alors que la couche intermédiaire 134 fournie sur le matériau piézoélectrique 114 est une couche d'oxynitrure de silicium, SiON. Ainsi, l'assemblage du substrat de manipulation massif 102 avec le matériau piézoélectrique 114 est ensuite réalisée à l'interface 130 entre deux couches diélectriques Si₃N₄ - SiON qui permet aussi une liaison stable.

Un substrat donneur 138 est ainsi obtenu après l'étape d) du procédé, comprenant une couche piézoélectrique 128 d'une épaisseur *t₂* de 20µm ou comprise entre 5µm et 20µm sur un substrat de manipulation massif 102 comprenant une zone de fragilisation 104, avec une interface d'assemblage 130 réalisée par deux couches intermédiaires à base de matériaux différents 132, 134.

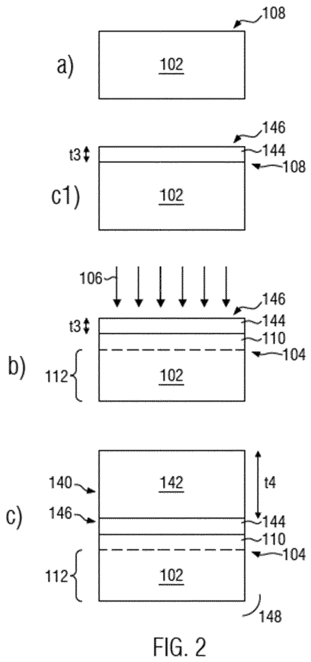

La figure 2 montre un deuxième mode de réalisation de l'invention du procédé de fabrication d'un substrat donneur. Dans ce deuxième mode de réalisation, l'étape c1) de fournir une couche intermédiaire et l'étape c) de fournir le matériau piézoélectrique sont différentes de celles décrites au premier mode de réalisation du procédé de fabrication. Les étapes a) et b) sont les mêmes que celles décrites au premier mode de réalisation du procédé de fabrication. Toutes les caractéristiques communes avec le premier mode de réalisation et utilisant le même numéro de référence que ci-dessus ne seront pas décrites à nouveau, mais il est fait référence à leur description détaillée ci-dessus.

Selon le deuxième mode de réalisation de l'invention, l'étape c) de fournir un matériau piézoélectrique 142 au-dessus du substrat de manipulation massif 102 est réalisée par déposition par épitaxie d'une couche 140 à base de matériau piézoélectrique 142.

Pour pouvoir fournir une couche 140 à base de matériau piézoélectrique 142 par épitaxie, une étape c1) est nécessaire pour fournir une couche de germe 144 (en anglais « seed ») pour la croissance épitaxiale successive d'une couche. Cette étape c1) de fournir une couche de germe 144 est réalisée aussi par déposition par épitaxie d'une couche à base de matériau piézoélectrique 142 à des températures comprises entre 970°C et 1050°C. Par exemple, le matériau piézoélectrique 142 déposé est à base de nitrure de gallium, GaN, mais il peut aussi être un autre type de matériau, tel que le nitrure d'aluminium, AlN. La couche de germe 144 comprend une épaisseur *t₃* de 50nm à 500nm.

Selon le procédé du deuxième mode de réalisation, lorsque l'étape c1) est réalisée et la couche de germe 144 est déposée sur la surface libre 108 du substrat de manipulation massif 102, l'étape b) d'implantation 106 du substrat de manipulation massif 102 est réalisée pour créer la zone de fragilisation 104 du substrat support massif 102. L'implantation 106 d'espèces atomiques ou ioniques est réalisée à travers la couche de germe 144 pour pénétrer dans l'intérieure du substrat support massif 102, incidente sur la surface supérieure 146 de la couche de germe 144.

Dans ce mode de réalisation, la dose d'implantation est inférieure à 6x10¹⁶ cm⁻², en particulier est inférieure à 5x10¹⁶ cm⁻². Une telle dose d'implantation dans le substrat de manipulation massif 102 permet d'augmenter la température à laquelle une fracture du substrat de manipulation 102 le long d'une zone de fragilisation 104 dans le substrat de manipulation 102 peut être obtenue. Par exemple, pour un substrat de manipulation massif 102 à base de carbure de silicium, SiC, la fracture du substrat 102 peut être obtenue dés 850°C, mais le fait d'utiliser une dose d'implantation de 4x10¹⁶ cm⁻² permet d'avoir une fracture du substrat 102 pour une température de 950°C.

Une fois l'étape b) d'implantation 106 réalisée sur le substrat de manipulation massif 102, l'étape c) de déposition de la couche 140 de matériau piézoélectrique 142 par épitaxie est réalisée. Cette déposition par épitaxie est réalisée directement sur la couche de germe 144, ce qui permet de déposer une couche 140 de matériau piézoélectrique 142 de bonne qualité par épitaxie.

L'étape c) de déposition par épitaxie du matériau piézoélectrique 142 est réalisée à une température inférieure à 950°C, en particulier à 900°C. L'épaisseur de la couche 140 de matériau piézoélectrique 142 formée est de 20µm, en particulier inférieure à 100µm.

Après l'étape c) du procédé, un substrat donneur 148 est obtenu comprenant une couche 140 de matériau piézoélectrique 142 d'une épaisseur de 20µm ou inférieure à 20µm sur un substrat de manipulation massif 102 comprenant une zone de fragilisation 104, avec une couche de germe 144 positionnée en sandwich entre la couche 140 de matériau piézoélectrique 142 et le substrat de manipulation massif 102.

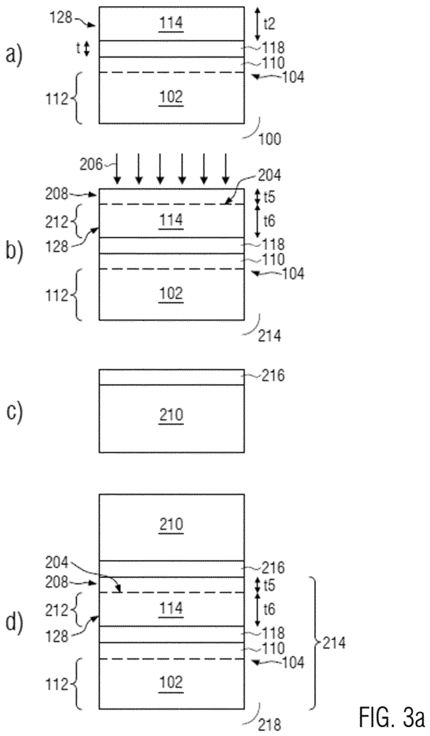

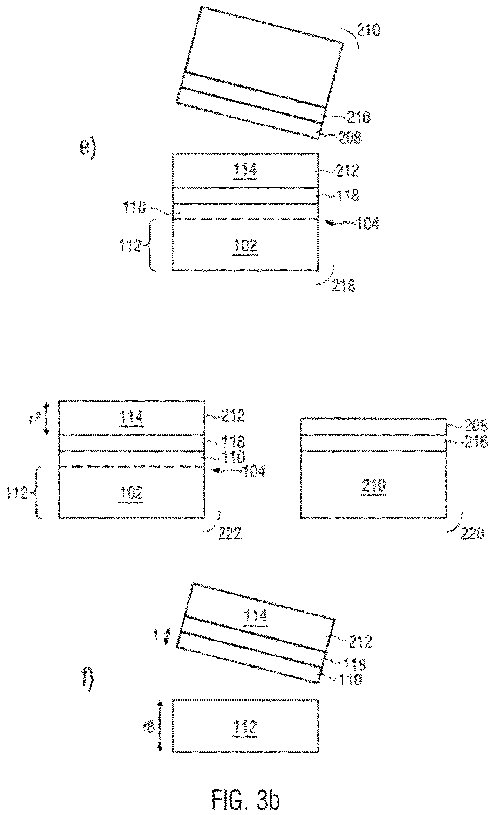

Le procédé de transfert d'une couche mince piézoélectrique selon un troisième mode de réalisation de l'invention est représenté schématiquement pour des raisons de clarté sur deux figures, les figures 3a et 3b. Mais le procédé de transfert selon l'invention comprend toutes les étapes a) à f) illustrées sur les figures 3a et 3b.

Le procédé de transfert d'une couche piézoélectrique sur un substrat support final selon l'invention comprend l'étape de fournir un substrat donneur obtenu par la mise en œuvre du procédé de fabrication d'un substrat donneur décrit par rapport aux Figures 1a, 1b et 2 selon le premier mode de réalisation de l'invention et ses variantes et selon le deuxième mode de réalisation de l'invention et ses variantes.

Le procédé de transfert d'une couche mince piézoélectrique commence par l'étape a) de fournir un substrat 200. Le substrat 200 correspond à un substrat donneur tel que décrit précédemment et selon l'invention. C'est-à-dire le substrat 200 peut être le substrat donneur 100 obtenu à l'étape d) de la Figure 1a, ou bien le substrat donneur 138 obtenu à l'étape d) de la Figure 1b ou encore le substrat donneur 148 obtenu à l'étape c) de la Figure 2.

Dans tous ces cas, le substrat donneur fournit à l'étape a) du procédé de transfert comprend une couche 128, 140 de matériau piézoélectrique 114, 122 d'une épaisseur de 20 µm ou inférieure à 20µm, sur un substrat de manipulation massif 102 comprenant une zone de fragilisation 104, avec au moins une couche intermédiaire 118, 132, 134, 144 positionnée en sandwich entre le substrat de manipulation massif 102 et la couche 128, 140 de matériau piézoélectrique 114, 122.

La au moins une couche intermédiaire 118, 132, 134, 144 peut-être une couche diélectrique 118, 132, 134, une couche polymère 118, réticulée ou non, ou bien encore une couche germe 144 déposée par épitaxie sur le substrat de manipulation massif 102.

Les figures 3a et 3b illustrent le procédé de transfert utilisant le substrat 100 obtenu à la figure 1a, mais comme indiqué ci-dessus, les substrats 138 et 148 peuvent aussi être utilisés. La figure 3a illustre les étapes a) à d) et la figure 3b illustre les étapes e) et f) du procédé de transfert.

Le procédé comprend ensuite une étape b) de former une zone de fragilisation 204 à l'intérieur de la couche 128 de matériau piézoélectrique 114 du substrat donneur 100, de manière à délimiter une couche piézoélectrique 208 à transférer sur un substrat support final 210.

Cette étape de formation d'une zone de fragilisation 204 est réalisée par une implantation 206 d'espèces atomiques ou ioniques dans la couche 128 de matériau piézoélectrique 114 du substrat donneur 100. L'implantation 206 atomique ou ionique est réalisée de telle manière que la zone de fragilisation 204 est située à l'intérieure de la couche 128 de matériau piézoélectrique 114 et sépare une couche piézoélectrique 208 du reste 212 de la couche 128 de matériau piézoélectrique 114. Les espèces atomiques ou ioniques sont implantées à une profondeur déterminée de la couche piézoélectrique 124 qui détermine l'épaisseur *t₅* de la couche piézoélectrique 208 à transférer et l'épaisseur *t₆* du reste 212 de la couche 128 de matériau piézoélectrique 114. L'épaisseur *t₅* est typiquement entre 50nm et 1µm, en particulier de l'ordre de 600nm.

Le substrat donneur 214 obtenu comprend une zone de fragilisation 204 séparant la couche piézoélectrique 208 à transférer du reste 212 de la couche 128 de matériau piézoélectrique 114.

L'étape c) du procédé de transfert selon l'invention comprend fournir un substrat support final 210. Le substrat final est un substrat massif à base de silicium. Le substrat support final 210 peut aussi être un substrat massif à base de carbure de silicium, SIC, de polySiC, polyAIN ou d'un matériau céramique fritté.

Selon l'invention, le substrat support final peut comprendre une couche 216. La couche 216 peut être une couche diélectrique, par exemple une couche à base d'oxyde de silicium, ou à base de nitrure de silicium, Si₃N₄, ou encore une couche comprenant une combinaison de nitrure et d'oxyde de silicium (oxynitrure de silicium), SiOₓN_{y}. La couche 216 peut également être formée par de l'oxyde d'aluminium, Al₂O₃, de l'oxyde d'hafnium, HfO₂ ou de l'oxyde de tantale, Ta₂O₅ ou autre matériaux ayant des propriétés fonctionnelles spécifiques, par exemple comme barrière de diffusion, une valeur d'impédance acoustique, ou encore le piégeage d'espèces contaminantes. L'épaisseur de la couche 216 est comprise entre 2nm et 1000nm. Suivant la technologie utilisée pour le collage, la couche 216 peut être également une couche de silicium ou de carbone amorphe ou de métal.

L'étape d) du procédé de transfert selon l'invention comprend assembler le substrat donneur 214 obtenu à l'étape b) du procédé avec le substrat final 210 pour obtenir un assemblage substrat support final -substrat donneur qui forme l'hétérostructure 218. L'assemblage du substrat donneur 214 avec le substrat support final 210 se fait au niveau de la couche 216, de telle manière que la couche 128 de matériau piézoélectrique 114 du substrat donneur 214 est en contact avec la couche 216 du substrat support 210.

Ensuite, une étape e) de réaliser une fracture le long de la zone de fragilisation 204 de la couche 128 de matériau piézoélectrique 114 pour séparer la couche piézoélectrique 208 du restant 212 de la couche 128 de matériau piézoélectrique 114 du substrat donneur est réalisée. Cette étape de fracture peut être réalisée thermiquement ou mécaniquement. Lors d'une séparation thermique, la température utilisée est inférieure à 600°C, en particulier inférieure à 300°C. Par exemple, un traitement thermique de 5h à 200°C peut être utilisé pour réaliser la fracture. Le traitement thermique réalisé permet de fracturer seulement la zone de fragilisation 204 de la couche 128 du matériau piézoélectrique 114. En effet, la zone de fragilisation 104 présente dans le substrat de manipulation massif 102 n'est pas fracturée lors de ce traitement thermique car l'apport thermique n'est pas assez important pour cela. La température utilisée est trop basse pour fracturer la zone de fragilisation 104 dans le substrat de manipulation massif 102.

Un substrat POI 220 illustré à l'étape e) de la Figure 3a est réalisé par le procédé de transfert d'une couche piézoélectrique selon l'invention et comprend un substrat support final 210, une couche 216 et une couche piézoélectrique 208 d'une épaisseur comprise entre 50nm et 1µm, en particulier de l'ordre de 600nm.

A la fin de l'étape e) du procédé de transfert, il reste aussi un substrat donneur 222 comprenant le substrat de manipulation massif 102 avec sa zone de fragilisation 104, la couche intermédiaire 118 et le restant 212 de la couche 128 de matériau piézoélectrique 114. La couche piézoélectrique 212 restante a une épaisseur t6 inférieure à l'épaisseur t2 de la couche 128. Et ainsi, le substrat donneur restant 222 peut être réutilisé dans un procédé de transfert selon les étapes a) et e) décrites précédemment tant que l'épaisseur *t₆* de la couche piézoélectrique 212 du restant du substrat donneur 222 obtenu à l'étape e) est supérieure à 5µm.

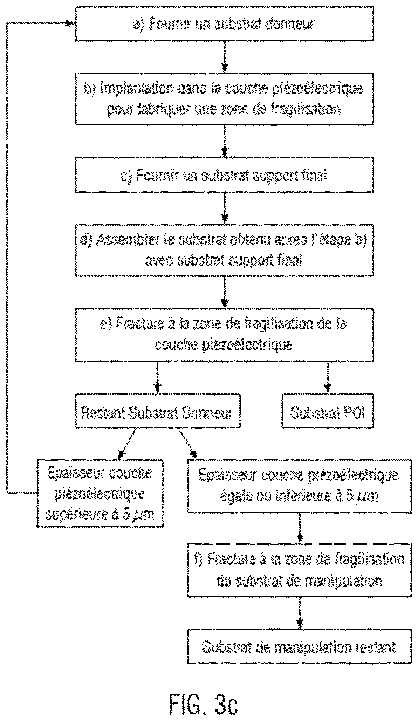

Ainsi, selon l'invention, les étapes a) à e) du procédé de transfert sont répétées au moins une fois. La réitération des étapes a) à e) du procédé de transfert sont illustrées avec un diagramme à la Figure 3c.

A partir de la deuxième itération, l'étape a) du procédé de fournir un substrat est réalisée avec le substrat 222 correspondant au restant du substrat donneur 100 obtenu à la fin de l'étape e) de l'itération précédente, c'est-à-dire le substrat donneur restant 222.

Lors de la deuxième itération du procédé, une étape b) d'implantation 206 est réalisée dans la couche piézoélectrique 212 du substrat donneur restant 222 pour réaliser une zone de fragilisation dans la couche piézoélectrique 212, étant la couche piézoélectrique restante sur le substrat donneur restant 222 après le transfert d'une couche mince piézoélectrique 208 sur le substrat support final 210 lors de la première itération du procédé de transfert.

Les étapes b), c), d) et e) sont répétées pour obtenir de nouveau un substrat POI 230 (non illustré) selon l'étape e) de la première itération. Les étapes sont les mêmes que celles décrites précédemment pour le procédé de transfert.

De même, après la deuxième itération de l'étape e) du procédé, un restant du substrat donneur 222, appelé substrat donneur 232 (non illustré), est obtenu avec une couche piézoélectrique 242 étant plus mince que la couche piézoélectrique 212, car une mince couche piézoélectrique a été transférée de la couche piézoélectrique 212 au substrat support final pour former un substrat POI 230.

A la fin de l'étape e) de la deuxième itération, si l'épaisseur de la couche piézoélectrique 242 restante dans le substrat donneur 232 est supérieure à 5µm, une nouvelle itération des étapes a) à e) est réalisée pour obtenir un autre substrat POI et ainsi de suite jusqu'à ce que l'épaisseur de la couche piézoélectrique restante 242 du restant du substrat donneur 222 soit égale ou inférieure à 5µm.

Lorsque l'épaisseur de la couche piézoélectrique 242 restante dans le substrat donneur restant 232 est égale ou inférieure à 5µm, une étape f) est alors réalisée. Le procédé de transfert selon les étapes a) à e) n'est pas réitéré.

L'étape f) est une étape de fracture le long de la zone de fragilisation 104 du substrat de manipulation massif 102 du restant du substrat 232. Ainsi, la couche 110 du substrat de manipulation massif 102 délimitée par la zone de fragilisation 104 est séparée du restant 112 du substrat de manipulation massif 102. De même, la couche intermédiaire 118 et la couche restante piézoélectrique 212 positionnée sur la couche 110 sont aussi séparées du restant 112 du substrat de manipulation massif 102.

Ainsi, après l'étape f) de fracture du substrat de manipulation massif 102 le long de la zone de fragilisation 104, un restant 112 du substrat de manipulation massif 102 ayant une épaisseur t8 est obtenu. L'épaisseur *t₈* du restant 112 du substrat de manipulation massif 102 est inférieure à l'épaisseur *t*' typique d'un substrat de manipulation massif 102. En effet, l'épaisseur *t₈* du restant 112 du substrat de manipulation massif 102 correspond à l'épaisseur *t*' du substrat de manipulation massif 102 initial dans le procédé de fabrication d'un substrat donneur moins l'épaisseur t de la couche 110 du substrat de manipulation 102 retirée lors de la fracture du substrat de manipulation massif 102.

Cette étape de fracture est réalisée par un traitement thermique.

Lorsque le substrat support fournit à l'étape a) correspond au substrat donneur 100 ou 138 de la Figure 1a ou 1b et a été fabriqué selon le procédé de fabrication du premier mode de réalisation et ses variantes, la température nécessaire pour le traitement thermique de fracture le long de la zone de fragilisation du substrat de manipulation massif est comprise entre 500°C et 600°C.

Lorsque le pseudo-substrat support fournit à l'étape a) correspond au substrat donneur 148 de la Figure 2 et a été fabriqué selon le procédé de fabrication du deuxième mode de réalisation et ses variantes, la température nécessaire pour le traitement thermique de fracture le long de la zone de fragilisation 104 du substrat de manipulation massif 102 est supérieure à 950°C, en particulier 1000°C.

Cette différence dans la température du traitement de fracture est due à la technique de fabrication utilisée pour le matériau piézoélectrique du substrat donneur. En effet, il est nécessaire que la fracture de la zone de fragilisation du substrat de manipulation massif ait lieu pour des températures différentes, et surtout plus élevées de celle utilisées pour la fracture de la zone de fragilisation du matériau piézoélectriques du substrat donneur fabriqué. La fracture de la zone de fragilisation du matériau piézoélectriques doit être réalisée avant la fracture de la zone de fragilisation du substrat de manipulation massif, donc à des températures plus basses.

Ainsi, le procédé de transfert d'une couche mince piézoélectrique selon l'invention comprend deux fractures différentes à deux endroits différents du substrat donneur, une première fracture le long de la zone de fragilisation dans la couche piézoélectrique et une deuxième fracture le long de la zone de fragilisation dans le substrat de manipulation massif. Les deux fractures sont réalisées par des apports thermiques différents, de sorte que les deux fractures ne peuvent pas être réalisées au même moment dans le procédé. Les deux fractures peuvent aussi être réalisées par des traitements mécaniques. Ainsi, le procédé de transfert d'une couche mince piézoélectrique selon le troisième mode de réalisation de l'invention permet d'obtenir plusieurs substrats piézoélectriques sur isolant (POI) à partir d'un seul substrat donneur fabriqué et permet d'obtenir aussi un restant de substrat de manipulation massif, qui peut être de nouveau utilisé dans d'autres procédés de fabrication.

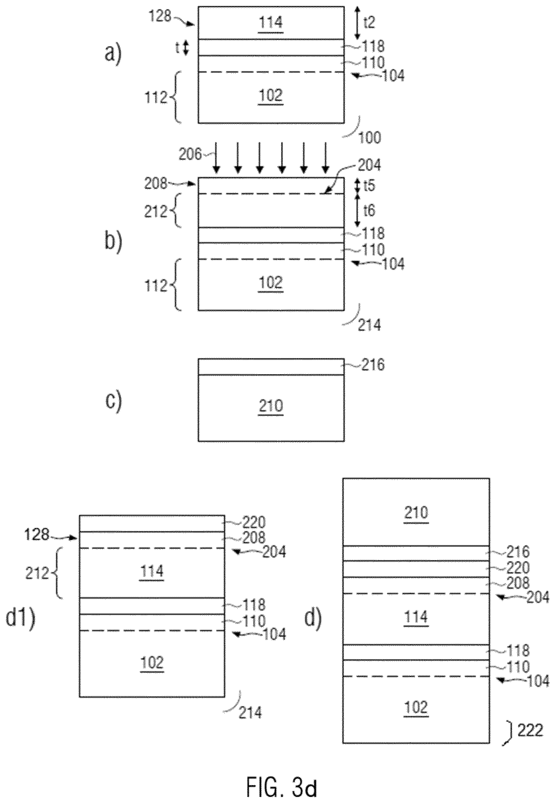

La Figure 3d montre une variante du troisième mode de réalisation de l'invention dans lequel l'étape d) d'attacher le substrat donneur au substrat support final pour obtenir un assemblage substrat donneur - substrat support final est différente par rapport au troisième mode de réalisation. Toutes les autres étapes a), b), c), e) et f) sont les mêmes que dans le troisième mode de réalisation. Toutes les caractéristiques communes avec le troisième mode de réalisation et utilisant le même numéro de référence que ci-dessus ne seront pas décrites à nouveau, mais il est fait référence à leur description détaillée ci-dessus.

Dans cette variante, avant l'étape d) d'assembler le substrat donneur 214 obtenu à l'étape b) du procédé au substrat support final 210, une étape de déposition d'une couche supplémentaire 220 peut être réalisée sur le substrat donneur 214. La formation de la couche supplémentaire 220 sur la couche 128 de matériau piézoélectrique 114 peut être réalisée par un dépôt par enduction centrifuge, ou « spin coating » en anglais ou par une technique de croissance thermique ou assisté par plasma telle que un dépôt chimique en phase vapeur activé par plasma PECVD (acronyme de l'expression anglaise « Plasma Enhanced Chemical Vapor Deposition ») ou la technique de dépôt physique en phase vapeur PVD (acronyme de l'expression anglaise « Physical Vapor Deposition »).

La couche 220 peut être une couche diélectrique, par exemple une couche à base d'oxyde de silicium, ou à base de nitrure de silicium Si₃N₄, ou encore une couche comprenant une combinaison de nitrure et d'oxyde de silicium SiOₓN_{y}. La couche 220 peut également être formée par de l'oxyde de aluminium, Al₂O₃, de l'oxyde d'hafnium, HfO₂ ou de l'oxyde de tantale, Ta₂O₅ ou autre matériaux ayant des propriétés fonctionnelles spécifiques, par exemple comme barrière de diffusion, une valeur d'impédance acoustique, ou encore le piégeage d'espèces contaminantes. L'épaisseur de la couche 220 est comprise entre 2nm et 1000nm.

Ainsi, lors de l'étape d) d'assemblage, l'interface d'assemblage a lieu entre la couche supplémentaire 220 du substrat donneur 214 et la couche 216 du substrat support final 210. Cette interface permet d'avoir une liaison stable entre le substrat donneur 214 et le substrat support final 210.

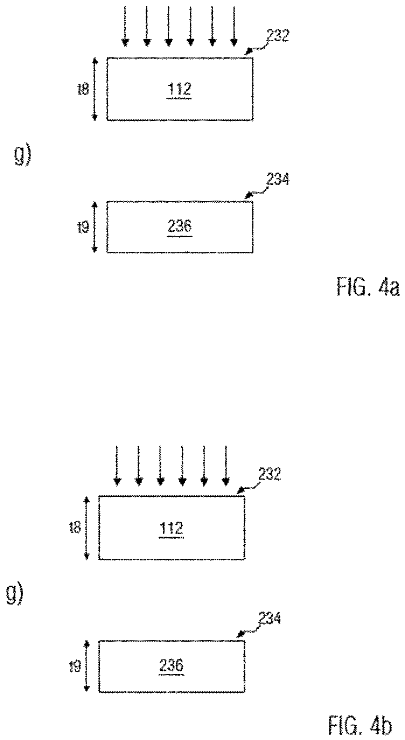

Figure 4a représente schématiquement un procédé de fabrication d'un substrat donneur selon un quatrième mode de réalisation de l'invention. Dans le quatrième mode de réalisation, l'étape a) de fournir un substrat de manipulation massif est différente par rapport au premier mode de réalisation. Toutes les autres étapes b), c), et d) sont les mêmes que dans le premier mode de réalisation. Toutes les caractéristiques communes avec le premier mode de réalisation et utilisant le même numéro de référence que ci-dessus ne seront pas décrites à nouveau, mais il est fait référence à leur description détaillée ci-dessus.

Selon le quatrième mode de réalisation de l'invention, l'étape a) de fournir un substrat de manipulation massif comprend utiliser le restant du substrat de manipulation massif obtenu après l'étape f) du procédé de transfert selon le troisième mode de réalisation de l'invention et ses variantes.

A la fin de l'étape f) de fracture du procédé de transfert du troisième mode de réalisation, comme illustré à la Figure 3a, un substrat restant 112 du substrat de manipulation massif 102 d'une épaisseur *t₈* est obtenu. L'épaisseur *t₈* du restant 112 du substrat de manipulation massif est inférieure à l'épaisseur *t*' typique d'un substrat de manipulation massif utilisé pour l'étape a) du procédé de fabrication d'un substrat donneur, comme décrit à la Figure 1a.

Après l'étape f) de fracture du procédé de transfert, une étape g) de nettoyage de la surface 232 du restant 112 du substrat de manipulation 102 est réalisée. Cette étape de nettoyage peut comprendre plusieurs traitements différents, comme par exemple un traitement nettoyant pour plastique (en anglais « DSS spray clean ») suivit d'une étape de nettoyage de type CMP (en français : polissage mécano-chimique, en anglais: chemical mechanical planarization). Le nettoyage de type CMP permet d'éliminer une surface de 550nm d'épaisseur du restant 112 du substrat de manipulation 102. Ainsi, un substrat de manipulation 236 avec une épaisseur finale *t₉* est obtenu à la fin de l'étape g) ayant une surface libre 234 propre. L'épaisseur *t*₉ est inférieure à *t₈,* l'épaisseur du substrat restant 112 après l'étape de fracture f).

Ces traitements de nettoyage sont nécessaires pour rendre la surface 234 du substrat de manipulation 236 libre de détritus et avec une rugosité qui permet au substrat de manipulation 236 d'être de nouveau utilisé dans un procédé de fabrication selon le premier mode de réalisation et ses variantes.

Une fois l'étape g) réalisée, les étapes suivantes a) à d) du procédé de fabrication selon le premier mode de réalisation et ses variantes peuvent être réalisées pour obtenir un substrat donneur pour être utiliser dans un procédé de transfert de couche mince piézoélectrique.

Ainsi, le procédé de fabrication selon l'invention permet de réutiliser un substrat de manipulation massif qui a déjà été utiliser dans un procédé de transfert de couche mince piézoélectrique au lieu de devoir fournir un nouveau substrat de manipulation massif, qui augmente le cout du procédé de fabrication d'un substrat POI.

Recycler une partie du substrat de manipulation massif selon l'invention permet donc de réduire le cout du procédé de fabrication d'un substrat POI.

Figure 4b représente schématiquement un procédé de fabrication d'un substrat donneur selon un cinquième mode de réalisation de l'invention. Dans le cinquième mode de réalisation, l'étape a) de fournir un substrat de manipulation massif est différente par rapport au deuxième mode de réalisation. Toutes les autres étapes b), c), et d) sont les mêmes que dans le deuxième mode de réalisation. Toutes les caractéristiques communes avec le deuxième mode de réalisation et utilisant le même numéro de référence que ci-dessus ne seront pas décrites à nouveau, mais il est fait référence à leur description détaillée ci-dessus.

Selon le cinquième mode de réalisation de l'invention, l'étape a) de fournir un substrat de manipulation massif comprend utiliser le restant du substrat obtenu après l'étape f) du procédé de transfert selon le troisième mode de réalisation de l'invention ou ses variantes.

A la fin de l'étape f) de fracture du procédé de transfert du troisième mode de réalisation, comme illustré à la Figure 3a, un substrat restant 112 du substrat de manipulation massif 102 d'une épaisseur *t₈* est obtenu. L'épaisseur *t₈* du restant 112 du substrat de manipulation massif est inférieure à l'épaisseur t' typique d'un substrat de manipulation massif utilisé pour l'étape a) du procédé de fabrication d'un substrat donneur, comme décrit à la Figure 1a.

Après l'étape f) de fracture du procédé de transfert, une étape g) de nettoyage de la surface 232 du restant 112 du substrat de manipulation 102 est réalisée. Cette étape de traitement comprend un ou plusieurs traitements thermiques, à des températures supérieures à 950°C, en particulier à des températures de 1000°C.

Ce traitement thermique permet de rendre la surface 234 du restant 112 du substrat de manipulation 236 libre de détritus pour pouvoir être de nouveau utilisé dans un procédé de fabrication selon le deuxième mode de réalisation et ses variantes.

Une fois l'étape g) réalisée, les étapes suivantes a) à d) du procédé de fabrication selon le deuxième mode de réalisation et ses variantes peuvent être réalisées pour obtenir un substrat donneur pour être utiliser dans un procédé de transfert de couche mince piézoélectrique.

Ainsi, le procédé de fabrication selon l'invention permet de réutiliser un substrat de manipulation massif qui a déjà été utiliser dans un procédé de transfert de couche mince piézoélectrique, au lieu de devoir fournir un nouveau substrat de manipulation massif, qui augmente le cout du procédé de fabrication d'un substrat POI.

Recycler une partie du substrat de manipulation massif selon l'invention permet donc de réduire le cout du procédé de fabrication d'un substrat POI.

## Revendications

1. Procédé de transfert d'une couche mince piézoélectrique comprenant:
a) fournir un substrat donneur (100, 138, 148) comprenant un substrat de manipulation massif (102), en particulier à base de silicium, avec une zone de fragilisation (104), et un matériau piézoélectrique (114, 142), le matériau piézoélectrique (114, 142) étant au-dessus du substrat de manipulation massif (102),
b) former une zone de fragilisation (204) à l'intérieur du matériau piézoélectrique (114, 142) du substrat donneur (100, 138, 148), en particulier par implantation ionique,
c) fournir un substrat support final (210), en particulier un substrat à base de silicium,
d) attacher le substrat donneur (100, 138, 148) au substrat final (120) pour obtenir un assemblage substrat donneur - substrat support final (218), et
e) réaliser une fracture le long de la zone de fragilisation (204) du matériau piézoélectrique (114, 142) pour séparer une couche piézoélectrique (208) du restant (222) du substrat donneur (100, 138, 148).

2. Procédé de transfert d'une couche mince piézoélectrique selon la revendication 1, dans lequel l'étape e) de fracture le long de la zone de fragilisation du matériau piézoélectrique (114, 142) est réalisée à une température inférieure à la température utilisée pour réaliser la fracture à la zone de fragilisation du substrat de manipulation massif (102) du substrat donneur (100, 138,148).

3. Procédé de transfert d'une couche mince piézoélectrique selon une des revendications 1 ou 2, dans lequel les étapes a) à e) sont répétées au moins une fois et à partir de la deuxième itération, l'étape a) est réalisée avec le restant (222) du substrat donneur (100, 138, 148) obtenu à la fin de l'étape e) de l'itération précédente.

4. Procédé de transfert d'une couche mince piézoélectrique selon la revendication 3, dans lequel les étapes a) à e) sont répétées tant que l'épaisseur de la couche piézoélectrique (212) du restant (222) du substrat donneur (100, 138, 148) obtenu à l'étape e) est supérieure à 5µm.

5. Procédé de transfert d'une couche mince piézoélectrique selon une des revendications 1 à 4, dans lequel une étape f) de fracture du restant (222) du substrat donneur (100, 138, 148) au niveau de la zone de fragilisation (104) du substrat de manipulation massif (102) est réalisée après l'étape e).

6. Procédé de transfert d'une couche mince piézoélectrique selon la revendication 5, dans lequel l'étape f) de fracture est réalisée lorsque l'épaisseur de la couche piézoélectrique (212) du restant (222) du substrat donneur (100, 138, 148) obtenu à l'étape e) est égale ou inférieure à 5µm, pour obtenir un restant (112) de substrat de manipulation massif (102).

7. Procédé de transfert d'une couche mince piézoélectrique selon la revendication 5, dans lequel l'étape f) de fracture le long de la zone de fragilisation (104) du substrat de manipulation massif (102) du restant (222) du substrat donneur (100, 138, 148) est réalisée par un traitement thermique.

8. Procédé de transfert d'une couche mince piézoélectrique selon la revendication 1, dans lequel le substrat donneur (100, 138, 148) fourni à l'étape a) est obtenu par la mise en œuvre d'un procédé de fabrication d'un substrat donneur pour le transfert d'une couche piézoélectrique sur un substrat support final,
ledit procédé de fabrication d'un substrat donneur pour le transfert d'une couche piézoélectrique sur un substrat support final comprenant les étapes de :
a) fournir un substrat de manipulation massif (102), en particulier à base de silicium;
c) fournir un matériau piézoélectrique (114, 142) au-dessus du substrat de manipulation massif (102); et
comprenant en outre une étape b) d'implantation (106) du substrat de manipulation massif (102) pour réaliser une zone de fragilisation (104) dans le substrat de manipulation massif (102) avant l'étape de fournir le matériau piézoélectrique (114, 142).

9. Procédé de transfert d'une couche mince piézoélectrique selon la revendication 8, dans lequel l'étape a) de fournir un substrat de manipulation massif (102) comprend utiliser le restant (112) du substrat de manipulation massif (112) obtenu après l'étape f) du procédé de transfert d'une couche mince piézoélectrique selon la revendication 5.

10. Procédé de transfert d'une couche mince piézoélectrique selon la revendication 9, dans lequel une étape g) de traitement de la surface (232) du restant (112) du substrat de manipulation massif (102) est réalisée après l'étape f) du procédé de transfert d'une couche mince piézoélectrique selon la revendication 5.

11. Procédé de transfert d'une couche mince piézoélectrique selon la revendication 8, dans lequel ladite étape b) d'implantation (106) du substrat de manipulation massif (102) est réalisée avec une dose d'implantation inférieure à 6*10¹⁶ cm⁻², en particulier inférieure à 5x10^{1e} cm⁻², encore plus en particulier une implantation d'hydrogène H, d'hélium, He ou une co-implantation d'hydrogène, H et d'hélium, He.

12. Procédé de transfert d'une couche mince piézoélectrique selon la revendication 8 ou 11, dans lequel une étape c1) de fournir une couche intermédiaire (118, 132, 134, 144) entre le substrat de manipulation massif (102) et le matériau piézoélectrique (114, 142) est réalisée avant ladite étape c) de fournir un matériau piézoélectrique (114, 142) au-dessus du substrat de manipulation massif (102).

13. Procédé de transfert d'une couche mince piézoélectrique selon la revendication 8, 11 ou 12, dans lequel ladite étape c) de fournir un matériau piézoélectrique (114) au-dessus du substrat de manipulation massif (102) comprend fournir un substrat massif à base de matériau piézoélectrique (114).

14. Procédé de transfert d'une couche mince piézoélectrique selon la revendication 13, dans lequel ladite étape c) de fournir un matériau piézoélectrique (114) au-dessus du substrat de manipulation massif (102) comprend en outre une étape d'assemblage du substrat de manipulation massif (102) avec le substrat massif à base de matériau piézoélectrique (114), en particulier par bondage moléculaire.

15. Procédé de transfert d'une couche mince piézoélectrique selon la revendication 8, 11, 12, 13 ou 14, dans lequel une étape d) d'amincissement du matériau piézoélectrique (114) est réalisée, en particulier par meulage, plus en particulier durant ledit procédé de fabrication d'un substrat donneur pour le transfert d'une couche piézoélectrique sur un substrat support final.

16. Procédé de transfert d'une couche mince piézoélectrique selon la revendication 15, dans lequel ladite étape d) d'amincissement du matériau piézoélectrique (114) est réalisée pour obtenir une couche (128) du matériau piézoélectrique (114) avec une épaisseur de 30µm ou moins, en particulier de 20µm ou moins.

17. Procédé de transfert d'une couche mince piézoélectrique selon la revendication 8, 11 ou 12, dans lequel ladite étape c) de fournir un matériau piézoélectrique (142) au-dessus du substrat de manipulation massif (102) est réalisée par déposition par épitaxie d'une couche (140) à base de matériau piézoélectrique (142) sur le substrat de manipulation massif (102).

18. Procédé de transfert d'une couche mince piézoélectrique selon la revendication 17, dans lequel l'étape de déposition par épitaxie est réalisée à une température inférieure à 950°C, en particulier inférieure à 900°C.

19. Procédé de transfert d'une couche mince piézoélectrique selon la revendication 1, dans lequel le substrat donneur (100, 138, 148) fourni à l'étape a) dudit procédé de transfert est **caractérisé en ce que** la zone de fragilisation (104) est positionnée à une profondeur t dans le substrat de manipulation massif (112) de 500nm, en particulier à une profondeur t dans le substrat de manipulation massif (112) de 300nm, encore plus en particulier à une profondeur t dans le substrat de manipulation massif (112) inférieure à 300nm.

20. Procédé de transfert d'une couche mince piézoélectrique selon la revendication 1 ou 19, dans lequel le substrat donneur (100, 138, 148) fourni à l'étape a) dudit procédé de transfert est **caractérisé en ce que** le substrat de manipulation massif (102) est un substrat de carbure de silicium, SiC , et le matériau piézoélectrique (114) est du nitrure de gallium, GaN.

## Patentansprüche

1. Verfahren zum Übertragen einer piezoelektrischen Dünnschicht, umfassend:
a) Bereitstellen eines Donatorsubstrats (100, 138, 148), umfassend
ein massives Handhabungssubstrat (102), insbesondere auf Siliziumbasis, mit einem Versprödungsbereich (104) und
ein piezoelektrisches Material (114, 142),
wobei das piezoelektrische Material (114, 142) über dem massiven Handhabungssubstrat (102) ist,
b) Ausbilden eines Versprödungsbereichs (204) im Inneren des piezoelektrischen Materials (114, 142) des Donatorsubstrats (100, 138, 148), insbesondere durch Ionenimplantation,
c) Bereitstellen eines finalen Trägersubstrats (210), insbesondere eines Substrats auf Siliziumbasis,
d) Binden des Donatorsubstrats (100, 138, 148) an das Endsubstrat (120), um eine finale Donatorsubstrat-Trägersubstrat-Anordnung (218) zu erhalten, und
e) Erzielen eines Bruchs entlang des Versprödungsbereichs (204) des piezoelektrischen Materials (114, 142) zum Trennen einer piezoelektrischen Schicht (208) von dem Rest (222) des Donatorsubstrats (100, 138, 148).

2. Verfahren zum Übertragen einer piezoelektrischen Dünnschicht nach Anspruch 1, wobei der Schritt e) des Brechens entlang des Versprödungsbereichs des piezoelektrischen Materials (114, 142) bei einer Temperatur erzielt wird, die niedriger als die Temperatur ist, die zum Erzielen des Bruchs an dem Versprödungsbereich des massiven Handhabungssubstrats (102) des Donatorsubstrats (100, 138, 148) verwendet wird.

3. Verfahren zum Übertragen einer piezoelektrischen Dünnschicht nach einem der Ansprüche 1 oder 2, wobei die Schritte a) bis e) mindestens einmal wiederholt werden und, ausgehend von der zweiten Iteration, der Schritt a) mit dem Rest (222) des Donatorsubstrats (100, 138, 148), der am Ende des Schritts e) der vorstehenden Iteration erhalten wird, erzielt wird.

4. Verfahren zum Übertragen einer piezoelektrischen Dünnschicht nach Anspruch 3, wobei die Schritte a) bis e) wiederholt werden, solange die Dicke der piezoelektrischen Schicht (212) Rests (222) des Donatorsubstrats (100, 138, 148), das in Schritt e) erhalten wird, größer als 5 µm ist.

5. Verfahren zum Übertragen einer piezoelektrischen Dünnschicht nach einem der Ansprüche 1 bis 4, wobei ein Schritt f) des Brechens des Rests (222) des Donatorsubstrats (100, 138, 148) an dem Versprödungsbereich (104) des massiven Handhabungssubstrats (102) nach dem Schritt e) erzielt wird.

6. Verfahren zum Übertragen einer piezoelektrischen Dünnschicht nach Anspruch 5, wobei der Schritt f) des Brechens, wenn die Dicke der piezoelektrischen Schicht (212) des Rests (222) des Donatorsubstrats (100, 138, 148), das in Schritt e) erhalten wird, gleich oder kleiner als 5 µm ist, zum Erhalten eines Rests (112) des massiven Handhabungssubstrats (102), erzielt wird.

7. Verfahren zum Übertragen einer piezoelektrischen Dünnschicht nach Anspruch 5, wobei der Schritt f) des Brechens entlang des Versprödungsbereichs (104) des massiven Handhabungssubstrats (102) von dem Rest (222) des Donatorsubstrats (100, 138, 148) durch eine Wärmebehandlung erzielt wird.

8. Verfahren zum Übertragen einer piezoelektrischen Dünnschicht nach Anspruch 1, wobei das Donatorsubstrat (100, 138, 148), das in Schritt a) bereitgestellt wird, durch Ausführen eines Verfahrens zum Herstellen eines Donatorsubstrats für die Übertragung einer piezoelektrischen Schicht auf ein finales Trägersubstrat erhalten wird,
das Verfahren zum Herstellen eines Donatorsubstrats für die Übertragung einer piezoelektrischen Schicht auf ein finales Trägersubstrat umfassend die Schritte:
a) Bereitstellen eines massiven Handhabungssubstrats (102), insbesondere auf Siliziumbasis;
c) Bereitstellen eines piezoelektrischen Materials (114, 142) über dem massiven Handhabungssubstrat (102); und
ferner umfassend einen Schritt b) des Implantierens (106) des massiven Handhabungssubstrats (102) zum Erzielen eines Versprödungsbereichs (104) in dem massiven Handhabungssubstrat (102) vor dem Schritt des Bereitstellens des piezoelektrischen Materials (114, 142).

9. Verfahren zum Übertragen einer piezoelektrischen Dünnschicht nach Anspruch 8, wobei der Schritt a) des Bereitstellens eines massiven Handhabungssubstrats (102) das Verwenden des Rests (112) des massiven Handhabungssubstrats (112), der nach dem Schritt f) des Verfahrens zum Übertragen einer piezoelektrischen Dünnschicht nach Anspruch 5 erhalten wird, umfasst.

10. Verfahren zum Übertragen einer piezoelektrischen Dünnschicht nach Anspruch 9, wobei ein Schritt g) des Behandelns der Oberfläche (232) des Rests (112) des massiven Handhabungssubstrats (102) nach dem Schritt f) des Verfahrens zum Übertragen einer piezoelektrischen Dünnschicht nach Anspruch 5 erzielt wird.

11. Verfahren zum Übertragen einer piezoelektrischen Dünnschicht nach Anspruch 8, wobei der Schritt b) des Implantierens (106) des massiven Handhabungssubstrats (102) mit einer Implantationsdosis von weniger als 6*10¹⁶ cm⁻², insbesondere weniger als 5x10¹⁶ cm⁻², noch spezieller eine Implantation von Wasserstoff H, Helium, He oder eine Co-Implantation von Wasserstoff, H und Helium, He erzielt wird.

12. Verfahren zum Übertragen einer piezoelektrischen Dünnschicht nach Anspruch 8 oder 11, wobei ein Schritt c1) des Bereitstellens einer Zwischenschicht (118, 132, 134, 144) zwischen dem massiven Handhabungssubstrat (102) und dem piezoelektrischen Material (114, 142) vor dem Schritt c) des Bereitstellens eines piezoelektrischen Materials (114, 142) über dem massiven Handhabungssubstrat (102) erzielt wird.

13. Verfahren zum Übertragen einer piezoelektrischen Dünnschicht nach Anspruch 8, 11 oder 12, wobei der Schritt c) des Bereitstellens eines piezoelektrischen Materials (114) über dem massiven Handhabungssubstrat (102) das Bereitstellen eines massiven Substrats auf Basis von piezoelektrischem Material (114) umfasst.

14. Verfahren zum Übertragen einer piezoelektrischen Dünnschicht nach Anspruch 13, wobei der Schritt c) des Bereitstellens eines piezoelektrischen Materials (114) über dem massiven Handhabungssubstrat (102) ferner einen Schritt des Anordnens des massiven Handhabungssubstrats (102) mit dem massiven Substrat auf Basis von piezoelektrischem Material (114), insbesondere durch molekulares Bonden, umfasst.

15. Verfahren zum Übertragen einer piezoelektrischen Dünnschicht nach Anspruch 8, 11, 12, 13 oder 14, wobei ein Schritt d) des Verdünnens des piezoelektrischen Materials (114), insbesondere durch Schleifen, noch spezieller während des Verfahrens zum Herstellen eines Donatorsubstrats für die Übertragung einer piezoelektrischen Schicht auf ein finales Trägersubstrat, erzielt wird.

16. Verfahren zum Übertragen einer piezoelektrischen Dünnschicht nach Anspruch 15, wobei der Schritt d) des Verdünnens des piezoelektrischen Materials (114) zum Erhalten einer Schicht (128) des piezoelektrischen Materials (114) mit einer Dicke von 30 µm oder weniger, insbesondere von 20 µm oder weniger, erzielt wird.

17. Verfahren zum Übertragen einer piezoelektrischen Dünnschicht nach Anspruch 8, 11 oder 12, wobei der Schritt c) des Bereitstellens eines piezoelektrischen Materials (142) über dem massiven Handhabungssubstrat (102) durch epitaktische Abscheidung einer Schicht (140) auf Basis von piezoelektrischem Material (142) auf dem massiven Handhabungssubstrat (102) erzielt wird.

18. Verfahren zum Übertragen einer piezoelektrischen Dünnschicht nach Anspruch 17, wobei der Schritt des epitaktischen Abscheidens bei einer Temperatur unter 950 °C, insbesondere unter 900 °C, erzielt wird.

19. Verfahren zum Übertragen einer piezoelektrischen Dünnschicht nach Anspruch 1, wobei das Donatorsubstrat (100, 138, 148), das in Schritt a) des Verfahrens zum Übertragen bereitgestellt wird,
**dadurch gekennzeichnet ist, dass** der Versprödungsbereich (104) in einer Tiefe t in dem massiven Handhabungssubstrat (112) von 500 nm, insbesondere in einer Tiefe t in dem massiven Handhabungssubstrat (112) von 300 nm, noch spezieller in einer Tiefe t in dem massiven Handhabungssubstrat (112) von weniger als 300 nm, positioniert ist.

20. Verfahren zum Übertragen einer piezoelektrischen Dünnschicht nach Anspruch 1 oder 19, wobei das Donatorsubstrat (100, 138, 148), das in Schritt a) des Verfahrens zum Übertragen bereitgestellt wird,
**dadurch gekennzeichnet ist, dass** das massive Handhabungssubstrat (102) ein Siliziumkarbidsubstrat, SiC, ist und das piezoelektrische Material (114) Galliumnitrid, GaN, ist.

## Claims

1. A method for transferring a piezoelectric thin film, comprising:
a) providing a donor substrate (100, 138, 148) comprising
a bulk handling substrate (102), in particular based on silicon, with an embrittlement zone (104), and
a piezoelectric material (114, 142),
the piezoelectric material (114, 142) being above the bulk handling substrate (102),
b) forming an embrittlement zone (204) inside the piezoelectric material (114, 142) of the donor substrate (100, 138, 148), in particular by ion implantation,
c) providing a final support substrate (210), in particular a silicon-based substrate,
d) attaching the donor substrate (100, 138, 148) to the final substrate (120) to obtain a donor substrate/final support substrate assembly (218), and
e) making a fracture along the embrittlement zone (204) of the piezoelectric material (114, 142) to separate a piezoelectric film (208) from the remnant (222) of the donor substrate (100, 138, 148).

2. The method for transferring a piezoelectric thin film according to claim 1, wherein step e) of fracturing along the embrittlement zone of the piezoelectric material (114, 142) is performed at a temperature lower than the temperature used to perform the fracturing at the embrittlement zone of the bulk handling substrate (102) of the donor substrate (100, 138, 148).

3. The method for transferring a piezoelectric thin film according to one of claims 1 or 2, wherein steps a) to e) are repeated at least once and, starting with the second iteration, step a) is carried out with the remnant (222) of the donor substrate (100, 138, 148) obtained at the end of step e) of the previous iteration.

4. The method for transferring a piezoelectric thin film according to claim 3, wherein steps a) to e) are repeated as long as the thickness of the piezoelectric film (212) of the remnant (222) of the donor substrate (100, 138, 148) obtained in step e) is greater than 5µm.

5. The method for transferring a piezoelectric thin film according to one of claims 1 to 4, wherein a step f) of fracturing the remnant (222) of the donor substrate (100, 138, 148) at the embrittlement zone (104) of the bulk handling substrate (102) is carried out after step e).

6. The method for transferring a piezoelectric thin film according to claim 5, wherein step f) of fracturing is carried out when the thickness of the piezoelectric film (212) of the remnant (222) of the donor substrate (100, 138, 148) obtained in step e) is equal to or less than 5µm, to obtain a remnant (112) of the bulk handling substrate (102).

7. The method for transferring a piezoelectric thin film according to claim 5, wherein step f) of fracturing the remnant (222) of the donor substrate (100, 138, 148) along the embrittlement zone (104) of the bulk handling substrate (102) is carried out by heat treatment.

8. The method for transferring a piezoelectric thin film according to claim 1, wherein the donor substrate (100, 138, 148) provided in step a) is obtained by implementing a method of manufacturing a donor substrate for transferring a piezoelectric film onto a final support substrate,
said method for manufacturing a donor substrate for transferring a piezoelectric film onto a final support substrate comprising the steps of:
a) providing a bulk handling substrate (102), in particular based on silicon;
c) providing a piezoelectric material (114, 142) above the bulk handling substrate (102); and
further comprising a step b) of implanting (106) the bulk handling substrate (102) to provide an embrittlement zone (104) in the bulk handling substrate (102) prior to the step of providing the piezoelectric material (114, 142).

9. The method for transferring a piezoelectric thin film according to claim 8, wherein step a) of providing a bulk handling substrate (102) comprises using the remnant (112) of the bulk handling substrate (112) obtained after step f) of the method for transferring a piezoelectric thin film according to claim 5.

10. The method for transferring a piezoelectric thin film according to claim 9, wherein a step g) of treating the surface (232) of the remnant (112) of the bulk handling substrate (102) is carried out after step f) of the method for transferring a piezoelectric thin film according to claim 5.

11. The method for transferring a piezoelectric thin film according to claim 8, wherein said step b) of implanting (106) the bulk handling substrate (102) is carried out with an implantation dose of less than 6*10¹⁶ cm⁻², in particular less than 5x10¹⁶ cm⁻², even more particularly an implantation of hydrogen H, helium He or a co-implantation of hydrogen H and helium He.

12. The method for transferring a piezoelectric thin film according to claim 8 or 11, wherein a step c1) of providing an intermediate film (118, 132, 134, 144) between the bulk handling substrate (102) and the piezoelectric material (114, 142) is performed prior to said step c) of providing a piezoelectric material (114, 142) above the bulk handling substrate (102).

13. The method for transferring a piezoelectric thin film according to claim 8, 11 or 12, wherein said step c) of providing a piezoelectric material (114) above the bulk handling substrate (102) comprises providing a bulk substrate based on piezoelectric material (114).

14. The method for transferring a piezoelectric thin film according to claim 13, wherein said step c) of providing a piezoelectric material (114) above the bulk handling substrate (102) further comprises a step of assembling the bulk handling substrate (102) with the bulk substrate based on piezoelectric material (114), in particular by molecular bonding.

15. The method for transferring a piezoelectric thin film according to claim 8, 11, 12, 13 or 14, wherein a step d) of thinning the piezoelectric material (114) is carried out, in particular by grinding, more particularly during said method for manufacturing a donor substrate for transferring a piezoelectric film onto a final support substrate.

16. The method for transferring a piezoelectric thin film according to claim 15, wherein said step d) of thinning the piezoelectric material (114) is performed to obtain a film (128) of the piezoelectric material (114) with a thickness of 30µm or less, in particular 20µm or less.

17. The method for transferring a piezoelectric thin film according to claim 8, 11 or 12, wherein said step c) of providing a piezoelectric material (142) above the bulk handling substrate (102) is performed by epitaxial deposition of a film (140) based on the piezoelectric material (142) on the bulk handling substrate (102).

18. The method for transferring a piezoelectric thin film according to claim 17, wherein the epitaxial deposition step is carried out at a temperature below 950°C, in particular below 900°C.

19. The method for transferring a piezoelectric thin film according to claim 1, wherein the donor substrate (100, 138, 148) provided in step a) of said transfer method is **characterized in that** the embrittlement zone (104) is positioned at a depth t in the bulk handling substrate (112) of 500nm, particularly at a depth t in the bulk handling substrate (112) of 300nm, even more particularly at a depth t in the bulk handling substrate (112) of less than 300nm.

20. The method for transferring a piezoelectric thin film according to claim 1 or 19, wherein the donor substrate (100, 138, 148) provided in step a) of said transfer method is **characterized in that** the bulk handling substrate (102) is a silicon carbide SiC substrate and the piezoelectric material (114) is gallium nitride GaN.
